Europäisches Patentamt

European Patent Office

Office européen des brevets

(19)

(11) Publication number: **0 359 207 B1**

## EUROPEAN PATENT SPECIFICATION

(12)

(45) Date of publication of patent specification: **02.02.94**

(51) Int. Cl.5: **H01L 31/108**, H01L 31/103, H01L 27/148

(21) Application number: **89116879.1**

(22) Date of filing: **12.09.89**

(54) **Infrared detector having homojunction structure.**

(30) Priority: **13.09.88 JP 230340/88**

(43) Date of publication of application:
**21.03.90 Bulletin 90/12**

(45) Publication of the grant of the patent:
**02.02.94 Bulletin 94/05**

(84) Designated Contracting States:
**DE GB NL**

(56) References cited:
**EP-A- 0 106 514**
**EP-A- 0 141 098**

**International Electron Devices Meeting 11 December 1988, SAN FRANSISCO, CA, USA pages 82 - 85; S.TOHYAMA ET AL.: "A NEW CONCEPT SILICON HOMOJUNCTION INFRARED SENSOR"**

(73) Proprietor: **NEC CORPORATION**
**7-1, Shiba 5-chome**
**Minato-ku**
**Tokyo 108-01(JP)**

(72) Inventor: **Tohyama, Shigeru**
**c/o NEC Corporation**
**33-1, Shiba 5-chome**
**Minato-ku Tokyo(JP)**

(74) Representative: **Glawe, Delfs, Moll & Partner**
**Patentanwälte**
**Postfach 26 01 62**
**D-80058 München (DE)**

## Description

### FIELD OF THE INVENTION

This invention relates to an infrared detector with optical cavity for converting an infrared radiation into an electric current.

### DESCRIPTION OF THE RELATED ART

Description is hereinbelow made for a prior art example of an infrared Schottky-barrier detector.

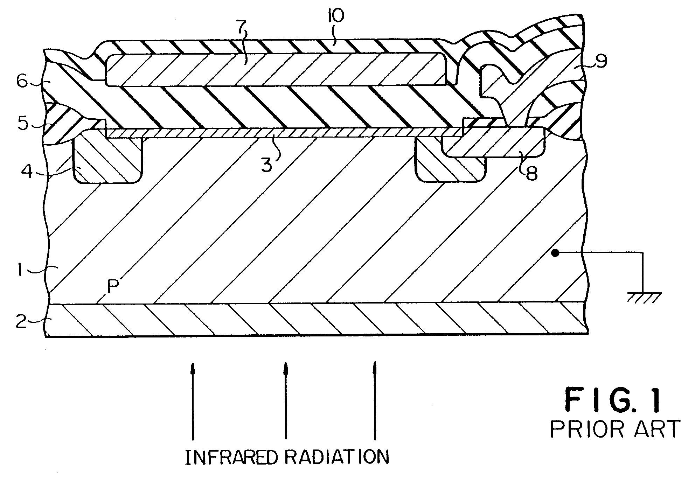

Fig. 1 is a cross sectional view showing the prior art example of the infrared Schottky-barrier detector which is of the back-illuminated type having a metal-and-p type semiconductor Schottky contact. The infrared detector is fabricated on a p-type single crystalline silicon substrate 1, and both of the surfaces are well polished. The incident or the back surface of the substrate 1 is coated with an anti-reflection film 2, and a platinum-monosilicide (represented by "PtSi") film 3 is formed on the front surface of the substrate 1 for providing a photo-electric converting region. An n-type guard ring 4 is formed along the peripheral area of the platinum-monosilicide film 3 so as to relieve a concentrated electric field, and a thermal oxide or silicon dioxide (represented by $SiO_2$) film 5 is grown around the platinum-monosilicide film 3. Using a chemical vapor deposition technique, on the platinum-monosilicide film 3 as well as the thermal oxide film 5 is deposited an insulating film 6 which is formed of silicon monoxide (SiO), silicon dioxide ($SiO_2$), or a silicon nitride represented by "SiN" or "$Si_3N_4$". For enhancement of the optical absorption, a metal mirror 7 of an aluminum is provided on the opposite surface to the platinum-monosilicide film 3, and, consequently, a multiple-level structure is fabricated by the combination of the p-type single crystalline silicon substrate 1, the platinum-monosilicide film 3, the insulating film 6 and the metal mirror 7 for producing an optical resonance. The thickness of the insulating film 6 is optimized in such a manner as to allow a standing wave produced by the infrared radiation with a target wavelength range to have the antinode in the platinum-monosilicide film 3. A heavily doped n-type impurity region 8 is brought into an ohmic contact with the platinum-monosilicide film 3, and a metal wiring 9 is coupled to the heavily doped n-type impurity region 8 for extracting an electric charge signal produced upon the photo-electric conversion. The entire surface of the multiple-level structure is covered with a passivation film 10, and the substrate 1 is grounded in an operation.

The substrate 1, the guard ring 4 and the heavily doped impurity region 8 of the prior art infrared Schottky-barrier detector are replaceable with an n-type single crystalline silicon, a p-type impurity region and a heavily-doped p-type impurity region, respectively, for fabricating another infrared detector of the type having a metal-and-n type semiconductor Schottky barrier. Moreover, if an infrared Schottky-barrier detector is of the front illumination type, the anti-reflection film 2 and the metal mirror 7 are eliminated from the back surface of the substrate 1 and the multiple-level structure, respectively, and the insulating film 6 and the passivation film 10 further serve as an anti-reflection film.

The prior art infrared Schottky-barrier detector thus arranged is fabricated through a process sequence similar to that for formation of a silicon integrated circuit, and a photo-detecting part of a solid-state infrared image sensor is easily implemented by using the infrared Schottky-barrier detectors arranged in an array. However, the photo-detecting part puts the electric charge signals on the output port of the solid-state infrared image sensor through a charge transfer system or a reading out system of the MOS scanning type.

In operation, since the Schottky barrier height formed between the platinum monosilicide and the p-type single crystalline silicon is as low as 0.2 eV to 0.25eV, a large amount of the carriers exceed the Schottky barrier at a room temperature due to the thermal excitement, and, accordingly, the dark current is increased. For reduction in the dark current, the solid-state infrared sensor is cooled off around the boiling point of the liquid nitrogen. A Schottky barrier height is dependent upon a combination of metal and semiconductor. Then, if the combination of metal and semiconductor decreases the Schottky barrier height, the solid-state infrared sensor needs a lower operation ambient, however, a higher Schottky barrier allows the solid-state infrared sensor to behave in a higher temperature. This means that an operating ambient should be established depending upon the Schottky barrier height.

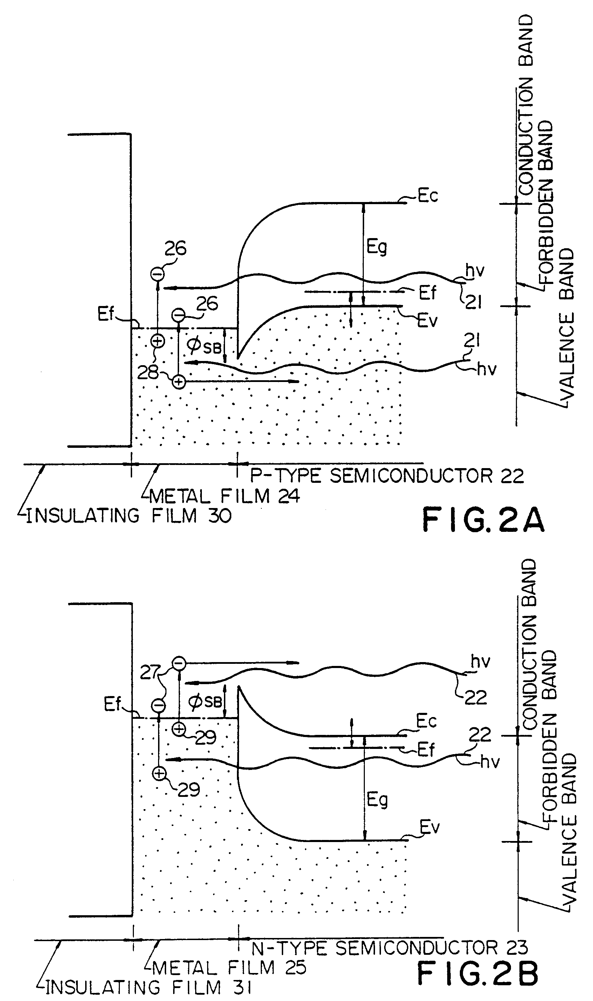

Subsequently, the behavior of the infrared Schottky-barrier detector is hereinbelow described with reference to Figs. 2A and 2B. Figs. 2 (A) and (B) respectively show energybands produced in the infrared Schottky-barrier detectors and illustrate photo-electric converting phenomena. Fig. 2(A) illustrates the photo-electric converting phenomenon which takes place in the infrared Schottky-barrier detector of the type having a Schottky barrier produced between a metal and a p-type semiconductor, and Fig. 2(B) show that of the infrared Schottky-barrier formed between a metal and an n-type semiconductor. In Figs. 2(A) and 2(B), Ec, Ef and Ev stand for bottom edges of conduction bands, Fermi levels and uppermost edges of valence bands, respectively. The infrared Schottky-barrier detectors are of the back illumination type, and, accordingly, infrared radiations 21 and 22 are incident on the p-type and n-type semiconductor 22 and 23 sides, respectively. If the infrared Schottky-barrier detector is of the front illumination type, the infrared radiations will be incident on the opposite sides. Whenever an optical radiation has a photon larger in energy than the width Eg of the forbidden band of the semiconductor material 22 or 23, most of the optical radiation will be absorbed in the vicinity of the incident surface of the semiconductor material. However, if the optical radiation has a photon smaller in the energy than the width Eg (and such an optical radiation usually belongs in the infrared range), the p-type or n-type semiconductor material 22 or 23 propagates it without probability that the valence electrons are excited by the photon through the absorption, and the optical radiation with the photon reaches a metal film 24 or 25 corresponding to the platinum-monosilicide film 3. In the metal film 24 or 25, since the energy levels below the Fermi level are filled with electrons, the photon transfers the energy thereof (equal to $h\nu$) to the electrons, and the electrons are excited from the energy levels below the Fermi level to vacant energy levels over the Fermi level. These excitements produce hot electron and hot hole pairs in the metal film 24 or 25, and the hot electrons and the hot holes are designated by reference numerals 26, 27, 28 and 29. Those hot electrons 26 and 27 as well as the hot holes 28 and 29 are moved in the metal films 24 and 25 until the recombinations, and the motions of the hot carriers take place with a certain probability in all of the directions.

In the infrared Schottky-barrier detector illustrated in Fig. 2A, if the hot holes 28 reaches the Schottky barrier with a height $\phi_{SB}$ and exceeds the Schottky barrier, the hot holes 28 thus entering the p-type semiconductor material 22 and the hot electrons 26 left in the metal film 24 participate electric currents serving as a signal. On the other hand, when the hot electrons 27 in Fig. 2B reach the Schottky barrier and exceed the barrier so as to enter the n-type semiconductor material 23, the hot electrons 27 in the n-type semiconductor material 23 as well as the hot holes 29 left in the metal film 25 serves as signal currents.

If the infrared Schottky-barrier detector is of the front illuminated type, the uppermost energy level of the photon available is larger than the width Eg of the forbidden band. The same phenomenon takes place in the infrared Schottky-barrier detector of the back illuminated type having a semiconductor substrate thin enough to be transparent to the optical radiation. In those infrared Schottky-barrier detectors, a free electron-and-free hole pair produced in the semiconductor material due to the photon excitement also participates the signal currents.

Although the hot carriers with the energy levels larger than the Schottky-barrier height $\phi_{SB}$ are partially reflected from the Schottky barrier at a certain rate due to the quantum effect, these hot carriers are reflected upon the interface between the insulating film and the metal film again, and, finally, a part of the hot carriers are supplied into the semiconductor material over the Schottky barrier.

Those phenomenon are conducive to enhancement of the supplying efficiency of the hot holes and the hot electron for the infrared Schottky-barrier detector illustrated in Fig. 2(A) or 2(B). The thinner the metal, the larger the supplying efficiency, so that it is desirable to decrease the thickness of the metal film in view of the supplying efficiency. However, a thinner metal film deteriorates the absorption efficiency for the infrared radiation. Thus, there is a trade-off between the supplying efficiency and the absorption efficiency, and, for this reason, the thickness of the metal film is optimized in view of these two sorts of the efficiencies so as to fabricate an effective multiple-level structure.

However, the prior art infrared Schottky-barrier detectors have the following problems. First, since the metal films 24 and 25 serving as the photoelectric converting regions usually have polycrystalline structures, a large amount of scattering centers take place due to the grain boundaries as well as the crystal defects of thereof. Even though the metal film is formed of an epitaxial silicide such as the platinum silicide with a clear orientation suitable to be combined with the single crystalline silicon, a large amount of the lattice mismatch takes place between the epitaxial silicide and the substrate, and a large amount of the grain boundaries and the crystal detects are produced so as to cancel an internal stress due to the lattice mismatch. Thus, the epitaxial silicide is not different from another metal film. The hot carriers lose the energies thereof upon the scattering phenomenon, and, for this reason, the grain boundaries and the crystal defects are effective to decrease the life times of the hot carriers. If the hot carriers lose the energy, the hot carriers hardly exceed the Schottky barrier in the repetitions of the reflections, and the supplying efficiency tends to be deteriorated.

Second, since a Schottky contact between a metal and a semiconductor is of the heterojunction, a large amount of the surface states take place along the junction, and the hot electrons and the hot holes are much liable to be captured by the surface states. This deteriorates the supplying efficiency of the hot holes in the Schottky-barrier between the metal and p-type semiconductor or the supplying efficiency of the hot electrons in the Schottky-barrier between the metal and n-type semiconductor.

Third, the optical radiation with the photon available is given as

$$\phi_{SB} < h\nu < Eg \qquad \text{(Equation 1)}$$

where $\phi_{SB}$ is the Schottky-barrier height, $h\nu$ is the photon energy, and Eg is the width of the forbidden band. Metal has a large number of the energy levels filled with the electrons below the Fermi level, but a large number of the vacant energy levels over the Fermi level, and a substantial amount of the optical radiation with the photon available merely is consumed to excite the hot holes with the energy levels hardly exceeding the Schottky-barrier height in the metal-and-p type semiconductor combination or to excite the hot electrons with the energy levels smaller than the Schottky-barrier height in the metal-and-n type semiconductor combination. In case of the metal-and-p type semiconductor combination, this phenomenon takes place upon the absorption of the photon energy for excitement of the electrons at the energy levels Ee falling within the range represented as

$$Ef - \phi_{SB} \leq Ee \leq Ef \qquad \text{(Equation 2)}$$

where Ef is the Fermi level. On the other hand, the electrons at the energy levels Ee′ fall within the range represented as the followings in case of the metal-and-n type semiconductor combination

$$Ef - h\nu < Ee' \leq Ef - h\nu + \phi_{SB} \qquad \text{(Equation 3)}$$

The phenomena will be understood from Figs. 2A and 2B. All of the hot carriers with the energy levels hardly exceeding the Schottky-barrier are not perfectly blocked by the barrier, because a part of the hot carriers passes the Schottky-barrier due to the tunnel effect. However, the hot carrier injection through the tunneling is extremely small in efficiency, and, accordingly, only a very small amount of the hot carriers participate in the signal currents. This means that a substantial amount of the photon energy is consumed for the excitement of the useless hot carriers. This energy loss is serious in the optical resonance produced in the back illuminated multiple-level structure provided with the semiconductor substrate, the metal electrode, the insulating film and the metal mirror as shown in Fig. 1.

In addition, if a semiconductor material with a wide forbidden band (Eg) is employed in the Schottky-barrier detector, the wavelengths available extend into the visual range. Furthermore, the infrared Schottky-barrier detector of the front illuminated type is responsive to the optical radiation with the photon energy larger than the width Eg of the forbidden band, and the detector with the back illuminated type is similar to the front illuminated type in so far as the semiconductor substrate is thinned to be transparent to the optical radiation with the photon energy larger than the energy energy gap Eg.

Fourth, the cut-off wavelength of the detector is mainly dependent upon the combination of the metal and the semiconductor, and, for this reason, the cut-off wavelength is hardly decided to be an arbitrary value. For example, the Schottky-barrier between the platinum-monosilicide and the p-type single crystalline silicon is about 5.6 micron in the cut-off wavelength, and this value can not be drastically changed.

## SUMMARY OF THE INVENTION

It is therefore an important object of the present invention to provide an infrared detector which has an improved junction boundary, and, for this reason, prolongs the life times of the hot holes or the hot electrons passing the junction boundary. This results in improvement on a utilization efficiency of the optical radiation absorbed.

It is another important object of the present invention to provide an infrared detector which has the cut-off wavelength arbitrarily selected.

To accomplish these objects, the present invention proposes to produce homojunctions between a photo-electric converting region and a potential barrier region and between a potential barrier region and a carrier receiving region.

In accordance with the present invention, there is provided an infrared detector comprising a) a photo-electric converting region formed of a first non-degenerative semiconductor material of a first conductivity type and operative to produce hot carriers in an optical radiation, b) a potential barrier region producing a first homojunction together with the photo-electric converting region and formed of a second semiconductor material for producing a potential barrier to the hot carriers, c) a carrier receiving region producing a second homojunction together with the potential barrier region and formed of a third non-degenerative semiconductor material of the first conductivity type having an impurity atom concentration lower than the first non-degenerative semiconductor material, a part of the hot carriers being supplied thereinto beyond the potential barrier region, and d) short-circuiting means for electrically interconnecting the photo-electric converting region and the potential barrier region, wherein the second semiconductor material is selected from the group consisting of a non-degenerative semiconductor material of the first conductivity type having an impurity atom concentration lower than the third non-degenerative semiconductor material, an intrinsic semiconductor material and a semiconductor material of a second conductivity type having an impurity atom concentration and a thickness selected in such a manner that depletion regions from the first and second homojunctions perfectly deplete the potential barrier region.

## BRIEF DESCRIPTION OF THE DRAWINGS

The features and advantages of an infrared detector according to the present invention will be more clearly understood from the following description taken in conjunction with the accompanying drawings in which:

Fig. 1 is a cross sectional view showing the structure of a prior art infrared Schottky-barrier detector of the back illuminated type;

Fig. 2A is an energyband diagram produced in the prior art infrared Schottky-barrier detector provided with a Schottky-barrier between a metal and a p-type semiconductor material;

Fig. 2B is an energyband diagram produced in the prior art infrared Schottky-barrier detector provided with a Schottky-barrier between a metal and an n-type semiconductor material;

Fig. 3A is an energyband diagram produced in an infrared detector according to the present invention in the thermal equilibrium state;

Fig. 3B is an energyband diagram produced in the infrared detector according to the present invention in an active operation mode;

Fig. 4A is an energyband diagram produced in another infrared detector according to the present invention in the thermal equilibrium state;

Fig. 4B is an energyband diagram produced in aforesaid another infrared detector in an active operation mode;

Fig. 5 is a cross sectional view showing the structure of an infrared detector embodying the present invention;

Fig. 6 is a cross sectional view showing the structure of another infrared detector embodying the present invention and forming part of a pixel of a charge coupled device;

Fig. 7 is a block diagram showing the charge-coupled device implemented by using the infrared detector shown in Fig. 6 embodying the present invention; and

Fig. 8 is a cross sectional view showing the structure of still another infrared detector embodying the present invention.

## PRINCIPLE ON WHICH THE PRESENT INVENTION IS BASED

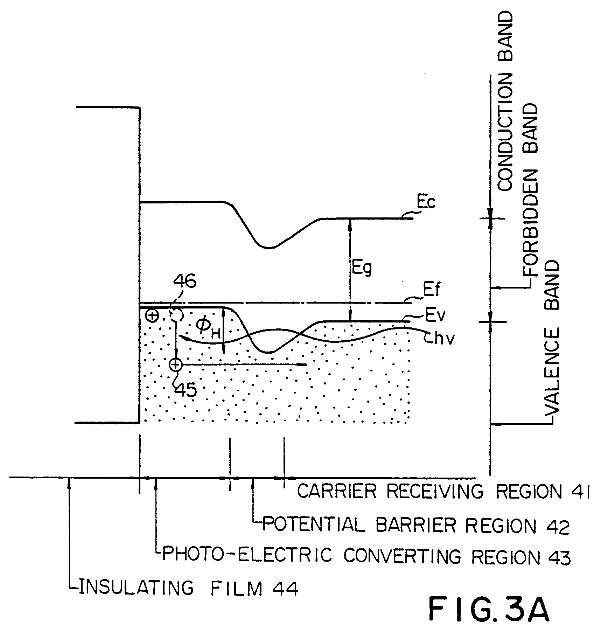

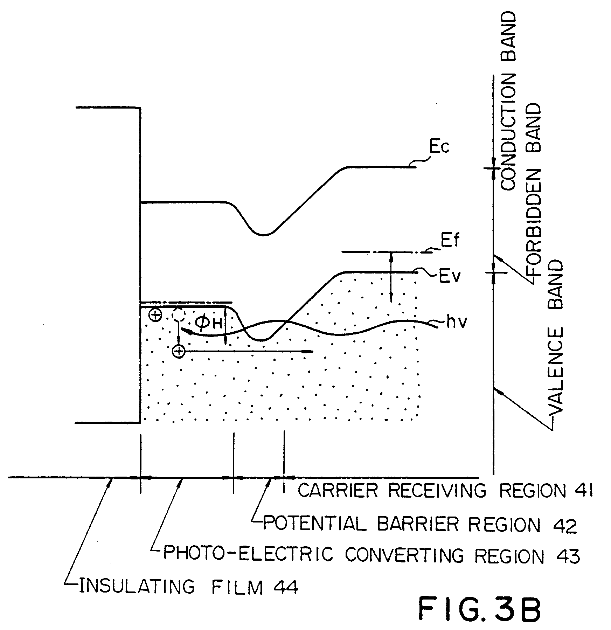

Referring first to Figs. 3A and 3B, an infrared detector according to the present invention comprises a carrier receiving region 41, a potential barrier region 42, a photo-electric converting region 43 and an insulating film 44, and homojunctions take place between the photo-electric converting region 43 and the potential barrier region 42 and between the potential barrier region 42 and the carrier receiving region 41. In this instance, the first and second conductivity types are respectively produced by acceptor and donor impurity atoms, and the photo-electric converting region 43 and the carrier receiving region 41 are formed of first and third p-type non-degenerative semiconductor materials, respectively. However, the third p-type non-degenerative semiconductor material is smaller in the impurity atom concentration than the first p-type non-degenerative semiconductor material. The Fermi levels Ef of the first and third p-type non-degenerative semiconductor materials are in the vicinity of the uppermost edges Ev of the valence bands, and the Fermi level Ef of the third p-type non-degenerative semiconductor material is closer to the mid energy level of the forbidden band. The potential barrier region 42 is formed of a second semiconductor selected from the group consisting of a p-type non-degenerative semiconductor material having an acceptor impurity atom concentration smaller than the third p-type non-degenerative semiconductor material, an intrinsic semiconductor material and an n-type semiconductor material having a donor impurity atom concentration and a thickness decided in such a manner that the potential barrier region is perfectly depleted by depletion regions extending from the homojunctions. This results in that the Fermi level Ef of the second semiconductor material is the closest to the bottom edge Ec of the conduction band of the three regions 41, 42 and 43. By virtue of this arrangement, potential barriers to holes in the valence bands take place between the potential barrier region 42 and the photo-electric converting and carrier receiving regions 41 and 43, respectively. The potential barrier to the holes in the photo-electric converting region 43 has a barrier height represented by $\phi_H$ in Figs. 3A and 3B.

Assuming now that the infrared detector shown in Figs. 3A and 3B are of the back illuminated type, an optical radiation with a photon $h\nu$ passes through the carrier receiving region 41 and the potential barrier region 42, and reaches the photo-electric converting region 43. If the photon energy is smaller than the energy gap Eg, the optical radiation is mainly of the infrared radiation, and the photon is hardly absorbed in the transition of electrons between the bands. However, the photon can be absorbed in the form of a free-carrier absorption. Since this absorption is negligible in a semiconductor material with a low free-carrier concentration, the third p-type non-degenerative semiconductor material is sufficiently small in the acceptor impurity atom concentration. However, the first p-type non-degenerative semiconductor material is large enough to absorb the photon of the optical radiation. Thus, the absorption takes place in the photo-electric converting region 43 only, and hot holes 45 are produced by excitement of holes 46. A part of the hot holes 45 exceeds the potential barrier between the photo-electric converting region 43 and the potential barrier region 42, and, then, reaches the carrier receiving region 41, thereby participating in a signal current.

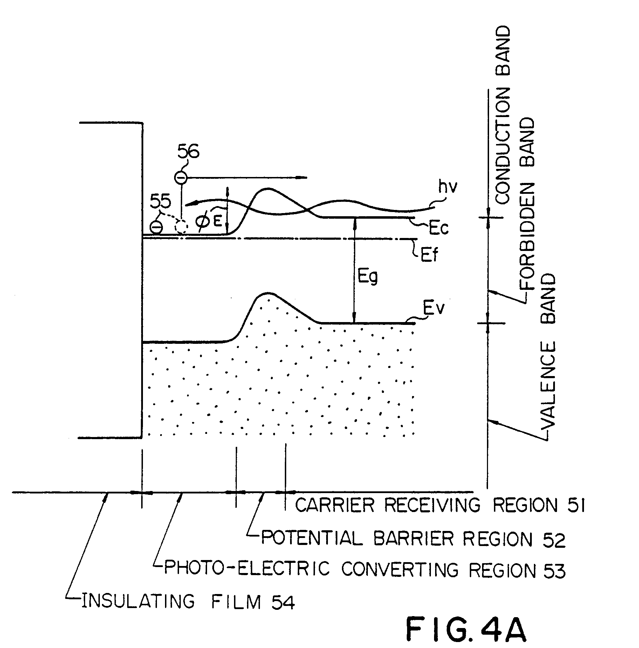

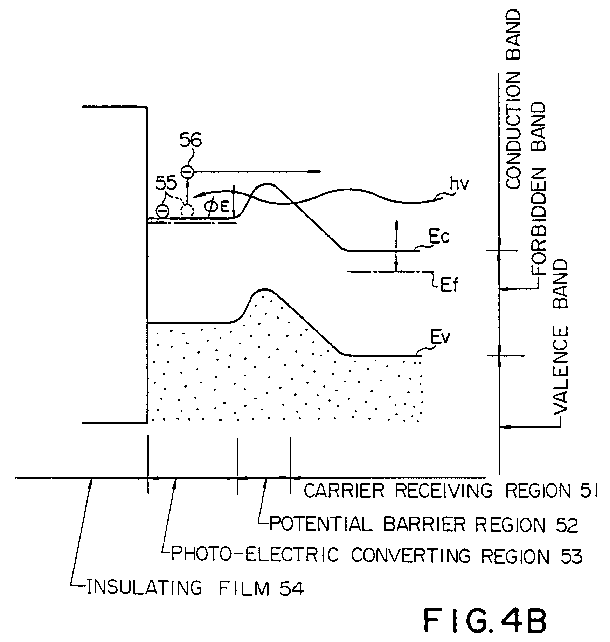

Turning to Figs. 4A and 4B of the drawings, another infrared detector of the back illuminated type according to the present invention comprises a carrier receiving region 51, a potential barrier region 52, a photo-electric converting region 53 and an insulating film 54, and the first and second conductivity types are produced by doping with donor impurity atoms and with acceptor impurity atoms, respectively. The photo-electric converting region 53 is formed by a first n-type non-degenerative semiconductor material, and the carrier receiving region is formed of a third n-type non-degenerative semiconductor material. Both of the Fermi levels Ef in the first and third n-type non-degenerative semiconductor materials are in the vicinity of the bottom edges Ec of the conduction bands, respectively, but the Fermi level Ef of the third n-type non-degenerative semiconductor material is closer to the mid energy level of the forbidden band. Homojunctions take place between the photo-electric converting region 53 and the potential barrier region 52 and between the potential barrier region 52 and the carrier receiving region 51, respectively. The potential barrier region 52 is formed of a second semiconductor material selected from the group consisting of a non-degenerative n-type semiconductor material smaller in the donor impurity atom concentration than the third n-type non-degenerative semiconductor material, an intrinsic semiconductor material and a p-type semiconductor material having a thickness and a donor impurity atom concentration selected in such a manner that the potential barrier region is perfectly depleted by depletion layers extending from the homojunctions in an active operation mode. This results in that the Fermi level Ef of the second semiconductor material is the closest to the uppermost edge Ev of the valence band of the three regions 51 to 53. The difference in the Fermi level produces potential barriers to electrons in the conduction bands between the photo-electric converting region 53 and the potential barrier region 52 and between the potential barrier region 52 and the carrier receiving region 51, respectively, and $\phi_E$ stands for the potential barrier height to the electrons in the conduction band of the photo-electric converting region 53.

In operation, if an optical radiation with a photon $h\nu$ is incident upon the infrared detector, the carrier receiving region 51 propagates the photon without the absorption, because the free carrier concentration is sufficiently low. The photon reaches the photo-electric converting region 53, and, then, excites the free electrons 55 to produce hot electrons 56. A part of the hot electrons 56 exceeds the potential barrier between the photo-electric converting region 53 and the potential barrier region 52, and are, accordingly, supplied to carrier receiving region 51 so as to participate in a signal current.

In the infrared detector according to the present invention, if a photon at the homojunctions is larger in energy than the energy gap, the photon causes not only aforementioned transition within the valence band or the conduction band but also the transition between the valence band and the conduction band. The present invention does not directly aim at the photo-electric conversion due to the later transition. However, this phenomenon is available in an infrared detector of the front illuminated type and in an infrared detector of the back illuminated type having a semiconductor subsrate thin enough to be transparent to an optical radiation with a photon energy larger than the energy gap Eg, because the transition takes place between the conduction band and the valence band at a high probability.

Assuming that the first conductivity type means the p-type, when the transitions of the electrons take place between the energy bands around the homojunctions, the electrons in the conduction bands are concentrated into the minimum energy portions in the potential barrier region. On the other hand, if the first conductivity type is tantamount to the n-type, the holes are produced in the valence bands due to the transitions of the electrons, and are concentrated into the maximum energy portions (or the minimum potential portions to the holes) in the potential barrier region. The free carriers should be rapidly removed therefrom, since the barrier height is varied due to the free carriers accumulated. These free carriers concentrated into the potential region are eliminated as useless carriers, or are extracted therefrom as a signal current, and, for this reason, the infrared detector according to the present invention is provided with short circuiting means interconnecting the photo-electric converting region and the potential barrier region.

In the infrared detector shown in Figs. 3A and 3B, the holes left in the valence band through the transitions of the electrons are partially supplied into the carrier receiving region 41, but the others remain in the photo-electric converting region 43. Similarly, a part of the free electrons produced through the transitions exceeds the potential barrier and reaches the carrier receiving region 41, however, the others are left in the photo-electric converting region 43 in the infrared detector shown in Figs. 4A and 4B. In either case, whenever the free electron and hole pair produced through the transition between the energy bands is separated between the photo-electric converting region 43 or 53 and the potential barrier region 42 or 52, the short circuiting means recombine them with one another. However, if the free electron and hole pair is separated between the potential barrier region 42 or 52 and the carrier receiving region 41 or 51, the free electron and the hole are independently extracted therefrom and available as signal charges.

In addition, when a low potential barrier is merely established in the infrared detector according to the present invention, a large amount of dark current takes place at the room temperature, and the infrared detector will be cooled off so as to decrease the dark current.

As will be understood from the foregoing description, the infrared detector according to the present invention is advantageous over the prior art infrared Schottky-barrier detector in the followings:

(1) Since the photo-electric converting region is formed of a non-degenerative semiconductor material similar to those providing other regions, no substantial difference takes place in quality of the crystal structure between the structure of the present invention and a bulk body, and, for this reason, the life time of the hot electrons or the hot holes is prolonged.

(2) The homojunction structure is achieved in the three essential regions of the infrared detector according to the present invention by using the non-degenerative semiconductor materials, and, therefore, the surface states are drastically decreased at the junctions of the three essential regions. The supplying efficiency of the hot holes or electrons are enhanced by virtue of the elimination of the surface states serving as the recombination centers.

(3) The infrared detector according to the present invention restricts the undesirable phenomenon where a photon of a detectable optical radiation is consumed by the excitement of the hot hole or the hot electron smaller in energy level than the potential barrier height $\phi_H$ or $\phi_E$ in comparison with the prior art infrared Schottky-barrier detector. This is because of the fact that the effective free carriers fall within an extremely narrow energy level range in the photo-electric converting region.

(4) The cut-off wavelength defined by the potential barrier height $\phi_H$ or $\phi_E$ is arbitrarily decided by selecting the conductivity type of the semiconductor material for the potential barrier region, the thickness of the potential barrier region, the impurity atom concentrations of the three essential regions and the biasing condition, and the potential barrier height ranges between zero and the built-in potential produced at the p-n junction.

## DESCRIPTION OF THE PREFERRED EMBODIMENTS

### First embodiment

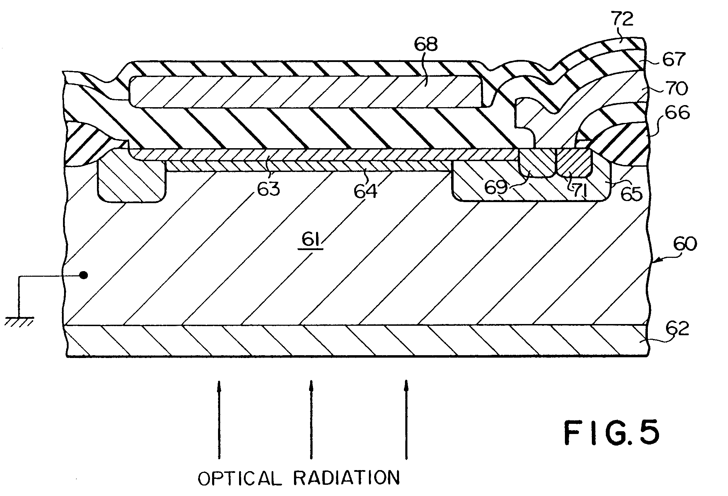

Referring first to Fig. 5 of the drawings, there is shown an infrared detector of the back illuminated type embodying the present invention. The infrared detector is fabricated on a p-type single crystalline silicon substrate 60, and both of the surfaces thereof are polished. The bulk body of the p-type single crystalline silicon substrate 61 provides a carrier receiving region 61, and the back surface of the p-type single crystalline silicon substrate 60 is coated with an anti-reflection film 62. The anti-reflection film 62 provides an incident surface where an optical radiation is fallen. The front surface portion of the substrate 60 is heavily doped with p-type impurity atoms, but the front surface portion is still non-degenerative. The relatively heavily doped front surface portion provides a p-type photo-electric converting region 63, and a potential barrier region 64 is formed between the photo-electric converting region 63 and the carrier receiving region 61. The potential barrier region 64 is formed of a p-type single crystalline silicon lower in the p-type impurity concentration than the carrier receiving region 61, an intrinsic single crystalline silicon or an n-type single crystalline silicon, the n-type impurity atom concentration of which is adjusted in such a manner that the potential barrier region 64 is perfectly depleted by depletion layers extending thereinto in an active operation mode. Such a silicon material is non-degenerative, and, for this reason, all of the essential regions 61, 63 and 64 are formed of the non-degenerative single crystalline silicon materials. In general, a non-degenerative semiconductor material has a good crystal structure in comparison with a degenerative semiconductor material, and, accordingly, the surface states are decreased.

An n-type guard ring 65 is provided around the photo-electric converting region 63 as well as the potential barrier region 64 so that the electric field is less concentrated. The potential barrier region 64 is sufficiently overlapped with the n-type guard ring 65, because the infrared detector loses the sensing action by a direct contact between the photo-electric converting region 63 and the carrier receiving region 61. The photo-electric converting region 63 is surrounded by a thermally grown silicon dioxide film 66, and the photo-electric converting region 63 and the thermally grown silicon dioxide film 66 are overlain by an insulating film 67 of silicon monoxide, silicon dioxide or a compound thereof deposited by a chemical vapor deposition technique. The insulating film 67 may be formed of a silicon nitrogen such as SiN or $Si_3N_4$. However, a thin silicon oxide film should be provided between the photo-electric converting region 63 and the silicon nitride film so as to relieve from a thermal stress due to a difference in thermal expansion coefficience. The thin silicon oxide film may be deposited by the chemical vapor deposition technique.

On the insulating film 67 is formed a metallic mirror 68 of, for example, aluminum which is disposed in an opposing relationship to the photo-electric converting region 63 for recovery of the photon passing through the photo-electric converting region 63. Thus, the carrier receiving region 61, the potential barrier region 64, the photo-electric converting region 63, the insulating film 67 and the metallic mirror 68 as a whole constitute an optical cavity for producing an optical resonance, and the thickness of the insulating film 67 is optimized in such a manner that an antinode of a standing wave produced by the optical radiation with a representative wavelength takes place in the photo-electric converting region 63. A heavily doped p-type impurity region 69 is formed in the n-type guard ring 65, and a metallic wiring 70 of, for example, aluminum is brought into contact with the heavily doped p-type impurity region 69 in an ohmic manner. In the n-type guard ring 65 is further formed a heavily doped n-type impurity region 71 which allows the metallic wiring 70 to contact therewith in an ohmic manner. The p-type heavily doped impurity region 69 is located in the vicinity of the n-type heavily doped impurity region 71, and the metallic wiring 70 is in contact with both of the p-type and n-type heavily doped impurity regions 69 and 71. The metallic wiring is partially alloyed with the p-type and n-type heavily doped impurity regions 69 and 71, and is led to the outside thereof. The entire surface of the structure is covered with a passivation film 72.

In this instance, short circuiting means for interconnecting the photo-electric converting region 63 and the potential barrier region 64 are formed in combination of the n-type guard ring 65, the n-type heavily doped impurity region 71, the metallic wiring 70 and the p-type heavily doped impurity region 69.

In operation, the optical radiation falls onto the anti-reflection film 62, and the carrier receiving region 61 and the potential barrier region 64 propagate the photon. The photon is absorbed in the photo-electric converting region 63 and, then, converted into the signal current. Namely, the infrared radiation allows the holes in the valence band to be exited to produce hot holes, and the holes thus produced are supplied into the carrier receiving region 61. The supply of the hot holes results in increasing the amount of the holes in the carrier receiving region 61, and the signal charges is discharged from the carrier receiving region 61 to the ground. On the other hand, the signal charges in the photo-electric converting region 63 is extracted through the p-type heavily doped impurity region 69 to the metallic wiring 70.

Second embodiment

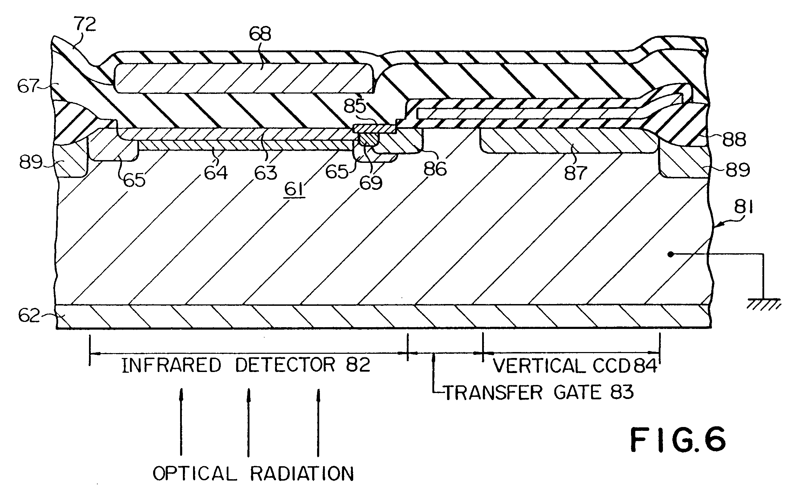

Turning to Fig. 6 of the drawings, another infrared detector embodying the present invention is fabricated on a p-type single crystalline silicon substrate 81, and is integrated into a two dimensional charge-coupled infrared image sensor of the interline transfer CCD (charge coupled device) type. Although a plurality of the infrared detectors are arranged in an array, only one infrared detector 82 for a pixel is illustrated in Fig. 6, and the pixel is provided with the infrared detector 82, a transfer gate 83 and a vertical CCD shift register 84.

The infrared detector 82 is similar in structure to the infrared detector shown in Fig. 5 with the exception of short circuiting means and means for extracting signal charges, and, for this reason, the corresponding regions and films are designated by like reference numerals used in the structure shown in Fig. 5 without any detailed description. The short circuiting means comprise the n-type guard ring 65, the p-type heavily doped impurity region 69, a silicide film 85 and an n-type heavily doped impurity region 86, and the n-type heavily doped impurity region 86 is not formed in the n-type guard ring 65, but is partially overlapped with the guard ring 65. Thus, the n-type heavily doped impurity region 86 projects from the guard ring 86, and provides a source region of the transfer gate 83. The silicide film 85 is brought into ohmic contact with both of the p-type and n-type heavily doped impurity regions 69 and 86. Although the silicide film 85 is replaceable with another conductive metal film, the silicide film is desirable in view of the reliability and stability.

The signal charges are extracted through the metallic wiring 70 of the infrared detector shown in Fig. 5, however, the signal charges are transferred from the infrared detector 82 through the transfer gate 83 to the vertical charge-coupled device 84.

The vertical charge-coupled device 84 is of the buried channel type. For reducing the width of an n-type channel 87 with respect to the charge transferring direction, a thermal oxide film 88 is increased in thickness on both sides of the charge-coupled device 84, and p-type heavily doped channel stopper regions 89 are formed under the thick thermal oxide film 88. Since the thick thermal oxide film is selectively grown, Fig. 6 does not show the thick thermal oxide film and the channel stopper region on the infrared detector side. However, the charge-coupled device train 84 are largely guarded by the thick thermal oxide films on both sides thereof.

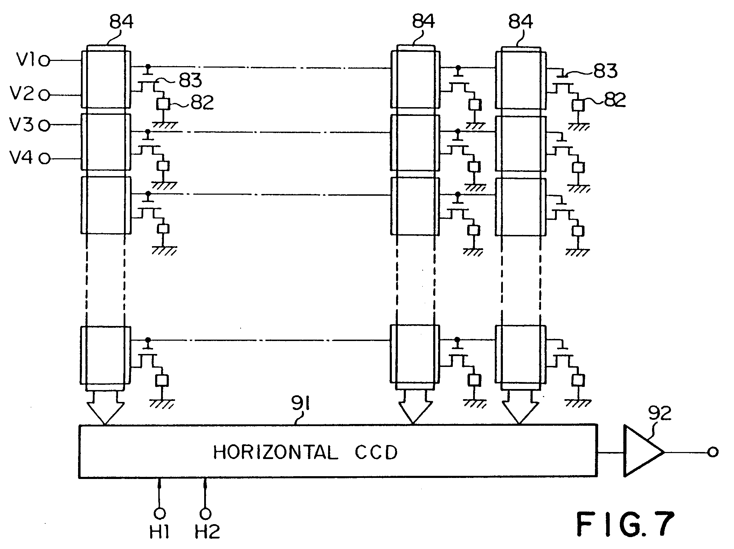

Fig. 7 shows the arrangement of the two dimensional infrared image sensor, and the image sensor is of the interline transferring type. The pixels are arranged in the two dimensional array, and the vertical charge-coupled devices 84 are coupled to a horizontal charge-coupled device 91 associated with an output circuit 92. The signal charges are transferred by each vertical charge-coupled device 84 in synchronization with four-phase clock signals V1, V2, V3 and V4, and the horizontal charge-coupled device 91 is driven with two-phase clock signals H1 and H2.

When the transfer gate 83 turns off and the infrared detector 82 is biased as shown in Fig. 3B, an accumulation mode of operation is established in the infrared detector 82 shown in Fig. 6. An incident infrared ray passes through the carrier receiving region 61 and the potential barrier region 63, and reaches the photo-electric converting region 63. The infrared radiation exites hte hole in the valence band to produce hot holes. The hot holes exceed the potential barrier, and are supplied into the carrier receiving region 61. The holes are finally discharged to the ground. The electrons are accumulated in the photo-electric converting region 63, the p-type heavily doped impurity region 69, the silicide film 85, the n-type heavily doped impurity region 86 and the n-type guard ring 65, and the accumulation of the electrons in the photo-electric converting region 63 and the p-type heavily doped impurity region 69 is carried out by reducing the majority carriers or the holes. While the signal charges are accumulated in the four regions, the vertical charge-coupled device trains 84 transfer signal charges accumulated in the previous accumulation mode of operation. Upon completion of the accumulation of the signal charges, the transfer gate 83 turns on, and, accordingly, the signal charges accumulated in the four regions are read out to the vertical charge-coupled device trains 84. When the signal charges are read out, the transfer gate 83 turns off again, and the infrared detector is shifted into the accumulation mode of operation again.

The signal charges thus read out are sequentially transferred to the horizontal charge-coupled device 91, and the signal charges produced in a row of the infrared detectors are concurrently transferred in a single horizontal period. The signal charges read out to the horizontal charge-coupled device 91 are read out from the horizontal charge-coupled device 91 through the output circuit 92 to the outside. The output circuit 92 comprises a capacitor and a source-follower amplifier, and is operative to convert the signal charges to a voltage signal as well as an impedance transformation. Thus, the reading out operation is sequentially repeated so that all of the signal charges accumulated are read out in the subsequent accumulation mode of the operation.

The two dimensional infrared image sensor shown in Figs. 6 and 7 is of the interline transferring type, however, various transferring types such as, for example, a MOS type are known in the art. The infrared detector embodying the present invention is applicable to these solid-state sensing devices. Moreover, if the infrared detector is fabricated by using other semiconductor materials such as, for example, germanium or gallium arsenide, the other component circuits such as a scanning unit may be formed on a single crystalline silicon substrate. In this implementation, three infrared detectors are coupled to the other component circuits in a hybrid manner.

Third embodiment

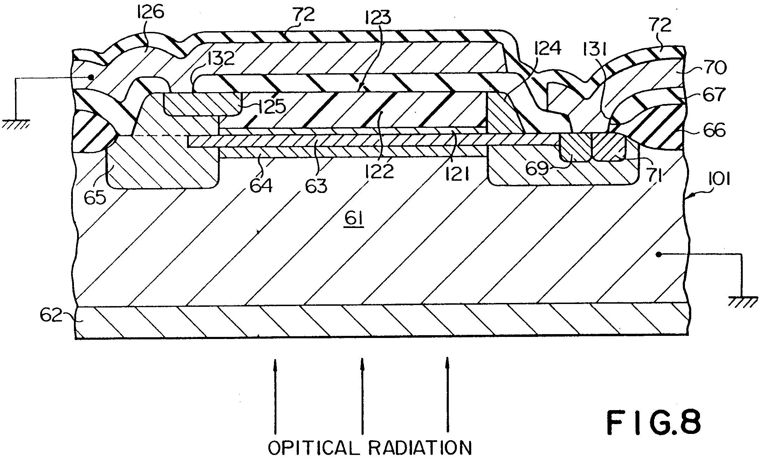

Turning to Fig. 8 of the drawings, still another infrared detector embodying the present invention is fabricated on a p-type single crystalline silicon substrate 101. The infrared detector is formed on the basis of the infrared detector shown in Fig. 5, and the corresponding component regions and films are denoted by like reference numerals used in Fig. 5 without any description.

The infrared detector shown in Fig. 8 further comprises a second potential barrier region 121 and a second carrier receiving region 122 of a lightly doped p-type so that the hot holes produced in the photo-electric converting region 63 are supplied into not only the carrier receiving region 61 but also the second carrier receiving region 122 beyond the potential barrier regions 64 and 121, respectively. By virtue of this structure, the quantum efficiency is enhanced. The second potential barrier region 121 and the second carrier receiving region 122 are formed in an epitaxial silicon layer 123 grown on the photo-electric convertion region 63.

The second potential barrier region 121 and the second carrier receiving region are surrounded by a second n-type guard ring 124, and a second p-type heavily doped impurity region 125 is formed in the surface portion of the epitaxial silicon layer 122 for providing an ohmic contact between the second carrier receiving region 122 and a second metallic wiring 126. The metallic wiring 126 serves as not only a conduction path but also a metallic mirror.

The single crystal silicon substrate 101 for the carrier receiving region 61 as well as the potential barrier region 64, the photo-electric converting region 63, the epitaxial silicon layer 123 for the second potential barrier region 121 and the second carrier receiving region 122, the insulating film 72, the metallic mirror 126 as a whole constitute an optical cavity for producing an optical resonance, and the thicknesses of the photo-electric converting region 63 and the epitaxial silicon layer 123 are optimized to have an antinode of a standing wave produced by a representative wavelength in the photo-electric converting region 63.

The metallic mirror or wiring 126 and the metallic wiring 70 are simultaneously formed in the insulating film 67, and the metallic wiring 70 penetrates through a contact window 131 formed in the insulating film 67 for being alloyed and in contact with both of the p-type and n-type heavily doped impurity regions 69 and 71. On the other hand, the metallic wiring 126 also comes into contact with the p-type heavily doped impurity region 125 and is alloyed. In this instance, the metallic film 126 is shared between the metallic mirror and the wiring, because the left side edge of the metallic mirror is located in the vicinity of the contained window 132 for the heavily doped impurity region 125. If the contact window 132 is separated from the left side edge of the mirror, two discrete metal strips will be formed for the metallic mirror and the wiring strip.

In this instance, the carrier receiving region 61 and the second carrier receiving region 122 are grounded, and signal charges are extracted from the photo-electric converting region 63 through p-type heavily doped impurity region 69 to the metallic wiring 70. However, the carrier receiving region 122 may be directly grounded without passing through the p-type heavily doped impurity region 125 and the metallic wiring 126.

A infrared image sensor is fabricated by using the infrared detectors of the type illustrated in Fig. 8, however, no further description is incorporated hereinunder.

As will be understood from the foregoing description, the infrared detector according to the present invention is compatible with the prior art infrared Schottky-barrier detector, since the both are the multiple-level structure similar to one another, and, for this reason, a wide variety of application will be found for the infrared detector according to the present invention. Moreover, the infrared detector according to the present invention have various advantages in that:

1) The photo-electric converting region is formed in an improved crystal structure capable of assuming a bulk body, and the life time of the hot carriers is prolonged.

2) The junctions where the hot carriers pass are improved, and the surface states are reduced.

3) The cut-off wavelength is arbitrarily selected by adjusting the potential barrier height.

In summary, any application such as the infrared image sensing unit is improved in capability by replacing the prior art Schottky-barrier detector with the infrared detector according to the present invention.

Although particular embodiments of the present invention have been shown and described, it will be obvious to those skilled in the art that modifications may be made. For example, another semiconductor material such as germanium or gallium arsenide is available for fabrication of an infrared detector according to the present invention. However, thermal oxides are hardly grown on the germanium and the gallium arsenide, and, for this reason, chemical vapor deposition techniques would be applied to the formation of the insulating films.

**Claims**

1. An infrared detector comprising a) a photo-electric converting region (63) formed of a first non-degenerative semiconductor material of a first conductivity type and operative to produce hot carriers in response to infrared optical radiation by free-carrier absorption, b) a potential barrier region (64) forming a first homojunction with said photo-electric converting region and formed of a second semiconductor material said first homojunction providing a potential barrier to said hot carriers, c) a carrier receiving region (61) forming a second homojunction with said potential barrier region and formed of a third non-degenerative semiconductor material of said first conductivity type having an impurity atom concentration lower than said first non-degenerative semiconductor material, a part of said hot carriers being supplied thereinto by passing over said potential barrier region, and d) short-circuiting means (70) for electrically interconnecting said photo-electric converting region and said potential barrier region, wherein said second semiconductor material is selected from the group consisting of a non-degenerative semiconductor material of said first conductivity type having an impurity atom concentration lower than said third non-degenerative semiconductor material, an intrinsic semiconductor material and a semiconductor material of a second conductivity type having an impurity atom concentration and a thickness selected in such a manner that depletion regions from said first and second homojunctions perfectly deplete said potential barrier region.

## Patentansprüche

1. Infrarotdetektor mit

   a) einem photoelektrischen Umwandlungsabschnitt (63), der auf einem ersten nichtdegenerativen Halbleitermaterial eines ersten Leitfähigkeitstyps ausgebildet ist und arbeitet, zur Erzeugung von heißen Trägern in Abhängigkeit von infraroter optischer Strahlung durch Absorption freier Träger,

   b) einem Potentialbarrieren-Abschnitt (64), der einen ersten Homoübergang mit dem photoelektrischen Umwandlungsabschnitt bildet und auf einem zweiten Halbleitermaterial ausgebildet ist, wobei der erste Homoübergangsabschnitt eine Potentialbarriere für die heißen Träger bildet,

   c) einem Trägerempfangsabschnitt (61) zur Erzeugung eines zweiten Homoübergangs mit dem Potentialbarrierenabschnitt, der aus einem dritten nichtdegenerativen Halbleitermaterial des ersten Leitfähigkeitstyps gebildet ist mit einer Fremdstoffatomkonzentration geringer als die des ersten nichtdegenerativen Halbleitermaterials, wobei ein Teil der heißen Träger ihm über den Potentialbarrierenabschnitt zugeführt wird, und

   d) einer Kurzschlußeinrichtung (70) zum elektrischen Verbinden des photoelektrischen Umwandlungsabschnittes und des Potentialbarrierenbereiches, wobei das zweite Halbleitermaterial aus der Gruppe ausgewählt ist, die besteht aus nichtdegenerativen Halbleitermaterialien des ersten Leitfähigkeitstyps mit einer Fremdstoffatomkonzentration geringer als die des dritten nichtdegenerativen Halbleitermaterials, einem intrinsischen Halbleitermaterial und einem Halbleitermaterial eines zweiten Leitfähigkeitstyps mit einer Fremdstoffatomkonzentration und einer Dicke, die so ausgewählt sind, daß Verarmungsregionen des ersten und des zweiten Homoübergangs perfekt den Potentialbarrierenabschnitt verarmen.

## Revendications

1. Détecteur infrarouge comprenant : a) une région de conversion photo-électrique (63) formée d'un premier matériau semi-conducteur non dégénéré d'un premier type de conductivité et agissant pour produire des porteurs chauds en réponse au rayonnement optique infrarouge par l'absorption des porteurs libres, b) une région de barrière de potentiel (64) formant une première homojonction avec la région de conversion photo-électrique et formée d'un second matériau semi-conducteur, la première homojonction procurant la barrière de potentiel aux porteurs chauds, c) une région de réception de porteur (61) formant une seconde homojonction avec la région de barrière de potentiel et formée d'un troisième matériau semi-conducteur non dégénéré du premier type de conductivité ayant une concentration d'atomes d'impuretés inférieure à celle du premier matériau semi-conducteur non dégénéré, une partie des porteurs chauds étant délivrée dans celle-ci en passant au-dessus de la région de barrière de potentiel, et d) un moyen de court-circuit (70) pour interconnecter électriquement la région de conversion photo-électrique et la région de barrière de potentiel, dans lequel le second matériau semi-conducteur est sélectionné dans le groupe qui est constitué du matériau semi-conducteur non dégénéré du premier type de conductivité ayant une concentration d'atomes d'impuretés inférieure à celle du troisième matériau semi-conducteur non dégénéré, un matériau semi-conducteur intrinsèque et un matériau semi-conducteur d'un second type de conductivité ayant une concentration d'atomes d'impuretés et une épaisseur sélectionnée d'une manière telle que les régions d'appauvrissement des première et seconde homojonctions appauvrissent parfaitement la région de barrière de potentiel.

**FIG. 1**
PRIOR ART

INFRARED RADIATION

FIG.2A

FIG.2B

FIG. 3A

CONDUCTION BAND
FORBIDDEN BAND
VALENCE BAND

Ec
Eg
Ef
Ev
hv
$\phi_H$
46
45

CARRIER RECEIVING REGION 41
POTENTIAL BARRIER REGION 42
PHOTO-ELECTRIC CONVERTING REGION 43
INSULATING FILM 44

14

FIG. 3B

CARRIER RECEIVING REGION 41

POTENTIAL BARRIER REGION 42

PHOTO-ELECTRIC CONVERTING REGION 43

INSULATING FILM 44

FIG.4A

CONDUCTION BAND

FORBIDDEN BAND

VALENCE BAND

56

55

$\phi$E

hv

Ec

Ef

Ev

CARRIER RECEIVING REGION 51

POTENTIAL BARRIER REGION 52

PHOTO-ELECTRIC CONVERTING REGION 53

INSULATING FILM 54

FIG.4B

FIG.5

OPTICAL RADIATION

INFRARED DETECTOR 82

VERTICAL CCD 84

TRANSFER GATE 83

OPTICAL RADIATION

FIG.6

FIG. 7

FIG.8